# EUROPÄISCHE PATENTANMELDUNG

(11) **EP 0 884 843 A2**
(43) Veröffentlichungstag der Anmeldung: **16.12.1998**
(21) Anmeldenummer: 98110567.9
(22) Anmeldetag: 09.06.1998
(51) Int. Cl.: H03H 9/64

(54) **Dualmode-Oberflächenwellenfilter**

(30) Priorität: 09.06.1997 DE 19724258
(71) Anmelder: SIEMENS MATSUSHITA COMPONENTS GmbH & CO. KG, 81541 München (DE)
(72) Erfinder: Baier, Thomas, Dr., 81539 München (DE); Strauss, Georg, Dr., 81667 München (DE)
(74) Vertreter: Epping, Wilhelm, Dr.-Ing.

(57) **Zusammenfassung**

Symmetrisch oder unsymmetrisch betreibbares Dualmode-Oberflächenwellenfilter mit einer akustischen Eingangsspur A mit in Serie geschalteten, durch Koppelwandler (KW3 bzw. KW5) getrennten und als Eingangswandler wirksamen Interdigitalwandlern (W3, W3; W5, W5) und mit einer akustischen Ausgangsspur B mit parallelgeschalteten Interdigitalwandlern (KW4, KW4; W6, W6) als Koppel- bzw. Ausgangswandler.

## Beschreibung

Die Erfindung betrifft ein im folgenden DMS-Filter genanntes, bevorzugt auf LiNbO₃ -oder LiTaO₃ -Basis realisiertes Dualmode-Oberflächenwellenfilter gemäß Oberbegriff des Anspruches 1, das insbesondere für HF-Anwendungen einsetzbar ist.

In Kommunikationssystemen werden Signale unsymmetrisch oder symmetrisch verarbeitet, wobei in der Signalführung häufig zwischen beiden Betriebsarten gewechselt und deshalb Filter angestrebt werden, die betrachtet - ein-ausgangsseitig - wahlweise symmetrisch/unsymmetrisch oder symmetrisch/symmetrisch betreibbar sind. Bestimmte Schaltungskonzepte erfordern Filter mit vorstehend genannten Eigenschaften und zusätzlich unterschiedlichen Ein- und Ausgangsimpedanzen.

Ein bekanntes DMS-Filter, das entsprechend diesen Forderungen symmetrisch oder unsymmetrisch betreibbar ist, zeigt in schematischer Darstellung Fig. 3. Die Struktur dieses DMS-Oberflächenwellenfilters besitzt über Koppelwandler KW1 und KW2 miteinander gekoppelte akustische Spuren AB mit je Spur innerhalb von kurzgeschlossenen Reflektoren 1 angeordneten Interdigitalwandlern W1, W2, die als Filterein- und -ausgangswandler wirken und seriell geschaltet sind. Soweit Filter dieser Art realisiert wurden, besaßen sie beidseitig, d.h. filterein- und ausgangsseitig, jeweils gleiche Impedanz nämlich 50 Ohm.

Aufgabe der Erfindung ist die Schaffung eines hochselektiven HF-Filters, das gleichfalls wahlweise symmetrisch oder unsymmetrisch betreibbar ist, wobei jedoch die Impedanz der Ein- und/oder Ausgangswandler im Gegensatz zum gezeigten bekannten DMS-Filter nach Fig. 3 wahlweise unterschiedlich festlegbar ist.

Zur Lösung dieser Aufgabe sieht die Erfindung bei einem DMS-Filter gemäß Oberbegriff des Anspruches 1 eine akustische Eingangsspur mit in Serie geschalteten, durch Koppelwandler getrennten und als Eingangswandler wirksamen Interdigitalwandlern vor, und eine akustische Ausgangsspur mit parallelgeschalteten Interdigitalwandlern als Koppel- oder Ausgangswandler.

Weitere Merkmale der Erfindung sind den Unteransprüchen, der Beschreibung und der Zeichnung entnehmbar.

Es zeigt jeweils in schematischer Darstellung
- Fig. 1:: ein erstes Ausführungsbeispiel eines DMS-Filters nach der Erfindung;
- Fig. 2:: ein zweites Ausführungsbeispiel eines DMS-Filters nach der Erfindung; und
- Fig. 3:: das eingans bereits erläuterte bekannte DMS-Filter.

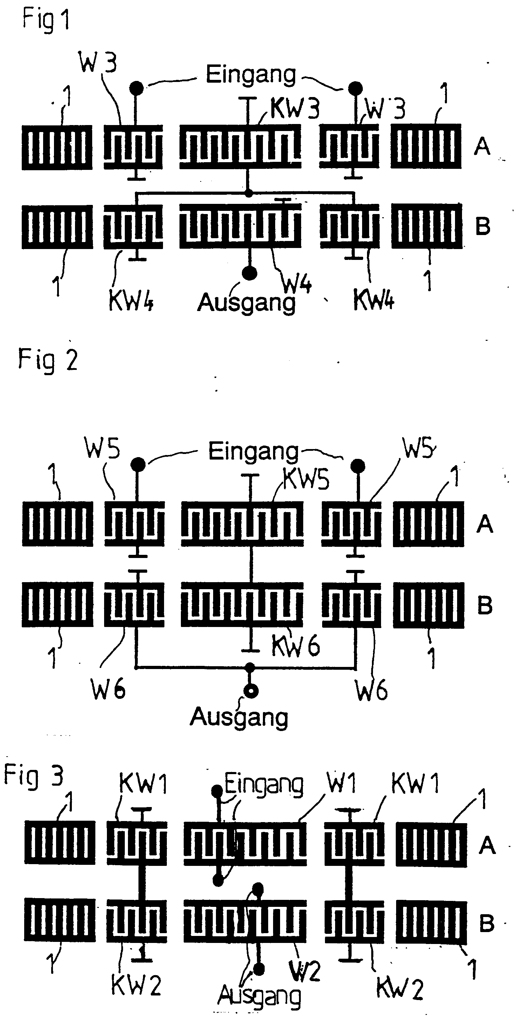

Das DMS-Filter gemäß Fig. 1 besitzt eine Eingangsspur A mit kurzgeschlossenen Reflektoren 1, 1, zwischen denen getrennt durch einen Koppelwandler KW3 in Serie geschaltete und als Eingangswandler wirksame Interdigitalwandler W3, W3 angeordnet sind. Die akustische Spur B enthält gleichfalls kurzgeschlossene Reflektoren 1, 1, zwischen denen zueinander parallelgeschaltete und als Koppelwandler wirksame Interdigitalwandler KW4, KW4 angeordnet sind, die durch einen Ausgangswandler W4 getrennt sind.

Fig. 2 zeigt ein DMS-Filter, dessen akustische Eingangsspur A hinsichtlich Gestaltung und Funktion der akustischen Spur A in Fig. 1 entspricht, d.h. auch die Interdigltalwandler W5, W5 und KW5 wirken als seriell geschaltete Eingangswandler bzw. Koppelwandler. Im Gegensatz zum Filter nach Fig. 1 erfolgt die Kopplung zwischen den akustischen Spuren A und B ausschließlich über einen einzelnen Koppelwandler KW6 in Spur B, der zwischen parallelgeschalteten als Ausgangswandler wirkenden Interdigitalwandlern W6, W6 angeordnet ist.

Durch die in Fig. 1 und 2 dargestellten DMS-Filter ist eine Impedanzerhöhung um den Faktor 4 erzielbar.

## Patentansprüche

1. Dualmode-Oberflächenwellenfilter, das symmetrisch oder unsymmetrisch betreibbar ist und über Koppelwandler miteinander gekoppelte akustische Ein- und Ausgangsspuren aufweist mit je Spur innerhalb von Reflektoren angeordneten, als Ein- bzw. Ausgangswandler wirksamen Interdigitalwandlern,
gekennzeichnet durch
eine akustische Eingangsspur A mit in Serie geschalteten, durch Koppelwandler (KW3 bzw. KW5) getrennten und als Eingangswandler wirksamen Interdigitalwandlern (W3, W3; W5, W5) und eine akustische Ausgangsspur B mit parallelgeschalteten Interdigitalwandlern (KW4, KW4; W6, W6) als Koppel- oder Ausgangswandler.

2. Dualmode-Oberflächenwellenfilter nach Anspruch 1, dadurch gekennzeichnet, daß die parallelgeschalteten, als Koppelwandler wirksamen Interdigitalwandler (KW4, KW4) durch einen Ausgangswandler (W4) getrennt sind (Fig. 1).

3. Dualmode-Oberflächenwellenfilter nach Anspruch 1, dadurch gekennzeichnet, daß die parallelgeschalteten, als Ausgangswandler wirksamen Interdigitalwandler (W6, W6) durch einen Koppelwandler (KW6) getrennt sind (Fig. 2).
